## Europäisches Patentamt
## European Patent Office
## Office européen des brevets

(19)

(11) Numéro de publication: **0 207 852**
**B1**

---

(12) **FASCICULE DE BREVET EUROPEEN**

(45) Date de publication du fascicule du brevet:
08.11.89

(21) Numéro de dépôt: 86401402.2

(22) Date de dépôt: 26.06.86

(51) Int. Cl.⁴: **H01L 21/60**, H01L 23/48,
G06K 19/06

---

(54) **Procédé de montage d'un circuit intégré sur un support, dispositif en résultant et son application à une carte à microcircuits électroniques.**

(30) Priorité: 26.06.85 FR 8509733

(43) Date de publication de la demande:
07.01.87 Bulletin 87/2

(45) Mention de la délivrance du brevet:
08.11.89 Bulletin 89/45

(84) Etats contractants désignés:
BE CH DE FR GB IT LI NL SE

(56) Documents cités:
FR-A- 2 337 381
FR-A- 2 439 438
US-A- 3 670 404
US-A- 3 868 724

(73) Titulaire: BULL S.A., 121, Avenue de Malakoff,
F-75116 Paris(FR)

(72) Inventeur: Dehaine, Gérard, 92, rue Gay-Lussac,
F-92320 Chatillon(FR)
Inventeur: Peytavy, Alain, 6, passage de Toulouse,
F-78000 Versailles(FR)

---

ACTORUM AG

## Description

L'invention se rapporte à un procédé de montage d'un circuit intégré sur un support, au dispositif résultant de la mise en oeuvre du procédé, et à l'application du dispositif à une carte à microcircuits électroniques et, plus particulièrement, à une carte portative dont l'épaisseur satisfait aux normes ISO (International Standard Organisation) des cartes de crédit, soit 0,76 mm ± 10 %.

On appelle carte à microcircuits électroniques, une carte faite ordinairement d'une feuille rectangulaire en matériau plastique, qui incorpore des microcircuits électroniques portés par un support et qui présente extérieurement des contacts pour la connexion des microcircuits électroniques avec un appareil de traitement de cartes. Les microcircuits électroniques peuvent être destinés à des fonctions très diverses, telles que par exemple les opérations bancaires de débit et de crédit, l'allocation d'unités téléphoniques et l'entrée confidentielle dans un milieu protégé. Ils constituent généralement des circuits de traitement et/ou de mémoire plus ou moins complexes selon l'usage auquel ils sont destinés. Dans la pratique, ils sont formés sur au moins une microplaquette de silicium, appelée couramment circuit intégré, puce ou chip. Pour des raisons de commodité, le terme "puce" sera utilisé dans la suite du texte.

Le support de puce contenu dans la carte est ordinairement une très mince feuille en matière plastique comportant les éléments d'interconnexion entre la ou les puces et les contacts de la carte. Dans un cas particulier, le support présente les contacts de la carte sur l'une de ses faces tandis que l'autre face porte la ou les puces et leurs éléments d'interconnexion avec les contacts. L'ensemble constitue un dispositif, appelé par la suite "pastille", incluant tous les éléments fonctionnels de la carte. La fabrication de la carte consiste alors seulement à incorporer la pastille dans le matériau plastique de la carte, de façon que les contacts de la pastille affleurent une face de la carte et que la puce et ses circuits soient protégés sous la pastille par une épaisseur minimale du matériau plastique de la carte. Le montage de la pastille se fait couramment par insertion dans une cavité de la carte, mais peut aussi bien se faire par enrobage dans le matériau plastique de la carte. L'invention concerne la fabrication d'une telle pastille.

Une pastille doit d'abord satisfaire aux conditions normales d'emploi des cartes souples portatives destinées au grand public. Pour ce faire, il faut que la pastille ait une résistance mécanique suffisante pour protéger la puce et ses éléments d'interconnexion à l'encontre des contraintes exercées sur le support lors des manipulations de la carte. Cependent, il faut qu'elle soit suffisamment souple pour épouser les flexions et torsions pouvant être ordinairement exercées sur la carte, sans endommager la puce, ses éléments d'interconnexion avec les contacts, et les soudures entre ces éléments et la puce.

Une pastille doit aussi pouvoir être incorporée dans une carte dont l'épaisseur est aux normes ISO des cartes de crédit, soit 0,76 mm ± 10 %, tout en laissant en-dessous de la pastille une épaisseur suffisante du matériau plastique de la carte pour la protection de la puce et de ses éléments d'interconnexion. En se référant aux valeurs nominales, il s'avère qu'en pratique l'épaisseur minimale du matériau plastique de protection est d'environ 0,20 mm, qui ne laisse ainsi à la pastille qu'une épaisseur de 0,56 mm. Dans la pastille, une puce occupe déjà une épaisseur de 0,30 mm, obtenue après rôdage de l'épaisseur d'origine d'une puce normale. Ceci ne laisse plus qu'une épaisseur possible de 0,26 mm pour l'ensemble du support, des contacts et des éléments de connexion des plots de la puce aux contacts respectifs de la pastille. Dans cet ensemble, on a vu précédemment que le support doit avoir une résistance mécanique suffisante qui, en pratique, requiert une épaisseur de l'ordre de 0,1 mm. Enfin, les contacts sont formés généralement à partir d'une feuille de cuivre collée sur le support, puis gravée et recouverte d'une couche d'or et d'au moins une couche intermédiaire de compatibilité, de nickel par exemple.

D'autre part, le procédé de fabrication d'une pastille doit être simple et bon marché pour convenir à une production en grande série de cartes à bas prix. Il est clair en effet qu'un procédé de fabrication en grande série de pastilles pour cartes n'est intéressant techniquement et commercialement que s'il fait intervenir le minimum de constituants et d'étapes. La simplicité est d'autant plus importante que, compte tenu des contraintes imposées sur l'épaisseur d'une pastille, la fabrication en série doit en outre s'accommoder à des marges de tolérance relativement grandes pour chaque élément de la pastille. La simplicité apparaît donc comme un facteur primordial et décisif dans le choix d'un procédé parmi tous les procédés possibles.

Enfin, dans la pratique, il s'avère que pour un grand nombre de services spécifiques différents, les cartes correspondantes requièrent l'emploi de puces de taille relativement grande, par exemple de l'ordre de 4 à 8 mm de côté. En outre, toute carte ne doit comporter qu'un nombre réduit de contacts, par exemple huit pour les cartes de crédit. Ceci limite à ce nombre les plots de la puce correspondante, qui peuvent même lui être inférieurs dans certains cas. Par conséquent, sur une grande puce, les plots peuvent être suffisamment écartés les uns des autres pour être directement connectés aux contacts respectifs de la puce. Cette possibilité simplifierait d'autant les procédés de fabrication et ne laisserait qu'au cas d'une puce très petite la nécessité de relier les plots de la puce aux contacts de la pastille par l'intermédiaire d'éléments de connexion tels que des fils et des conducteurs libres ou solidaires du support.

Les procédés antérieurs de fabrication de pastilles ne satisfont pas à toutes les conditions qui viennent d'être énoncées, surtout si les pastilles sont destinées à des cartes à épaisseur normalisée.

La fabrication actuelle est celle conforme au brevet français n° 2 439 478 de la demanderesse. Le procédé consiste à percer des trous dans le support, à coller une feuille de cuivre sur une face du support et à la graver puis la dorer pour former les contacts de la pastille, à métalliser les trous, puis à procéder aux étapes de dépôt et de photogravure d'une couche conductrice sur l'autre face du support pour former des plages de connexion, et à souder sur ces plages de connexion les éléments d'entrée-sortie des circuits intégrés portés par une ou deux puces. En d'autres termes, ce procédé a recours à la technologie des trous métallisés et à une métallisation sur les deux faces du support. Ainsi, en plus de la complexité de ce procédé, la pastille qui en résulte s'avère coûteuse et encombrante.

Une variante actuellement mise en oeuvre, consiste à ménager une ouverture dans le support pour coller la puce directement sur une partie de la feuille de cuivre qui bouche cette ouverture. Comme avantages, la pastille correspondante a une faible épaisseur du fait que l'épaisseur du support ne s'ajoute pas à celle de la puce, et la partie de cuivre sous la puce favorise l'évacuation des calories issues des microcircuits et peut servir à la polarisation d'une puce de type N-MOS. Cependant, la liaison directe de la puce avec la mince feuille de cuivre extérieure a l'inconvénient de rendre la puce plus sensible aux forces de pression, de torsion et de flexion susceptibles d'être exercées sur les cartes souples de grand public dans les conditions normales d'emploi. D'autre part, le procédé de fabrication demeure complexe et couteux, et nécessite en plus la connexion par fils des plots de la puce aux plages de connexion avec les contacts.

Un perfectionnement à ces procédés de fabrication a été présenté dans les brevets francais n° 2 439 322 et 2 439 438 de la demanderesse. Selon ce perfectionnement, les extrémités des pattes de la puce sont fixées directement aux contacts respectifs dans des trous percés dans le support, fermés par les contacts et remplis au moins partiellement de brasure. Cependant, l'adjonction de la brasure dans les trous est une étape délicate du procédé. D'autre part, avant ou pendant le brasage, il faut procéder à une opération aussi délicate de cambrage des pattes.

Il est à noter que les procédés antérieurs qui viennent d'être présentés ont, en plus de leurs défauts propres, un inconvénient qui leur est commun. En effet, tous ces procédés requièrent la présence d'éléments de connexion entre les plots de la puce et les contacts de la pastille. Ces éléments de connexion sont des fils de liaison, ou les pattes des puces, ou des conducteurs formés à partir d'une couche métallique reposant sur la face intérieure du substrat de la pastille, ou une combinaison de ces éléments. L'emploi de fils de connexion correspond à la technologie dite "wire bonding". L'adjonction de pattes aux puces peut être faite par la technique de montage de puces sur ruban, appelée couramment TAB (Tape Automatic Bonding). Enfin, la formation de conducteurs sur le support peut être faite par collage et gravure d'une feuille de cuivre, ou par dépôt métallique. En d'autres termes, les procédés antérieurs font tous intervenir nécessairement des étapes de procédé coûteuses et parfois délicates.

L'invention satisfait à toutes les conditions énoncées plus haut et offre ainsi l'avantage d'obtenir aisément et à bas prix une pastille mécaniquement résistante, de faible épaisseur, de structure simple et permettant la connexion directe des plots de la puce aux contacts de la pastille.

L'invention concerne d'abord un procédé de montage d'un circuit intégré sur un support consistant à percer des trous dans le support, à fermer les trous par une couche métallique appliquée sur une face du support et à souder en regard des trous les éléments de connexion du circuit intégré à la couche métallique, caractérisé en ce que, avant le soudage, il consiste à déformer la couche métallique vers l'intérieur de chacun des trous pour y constituer des bossages.

En corollaire, un dispositif porteur de circuits intégrés conforme à l'invention, comprenant un support percé de trous et ayant une face pourvue d'une couche métallique fermant les trous, est caractérisé en ce que la couche métallique présente des bossages vers l'intérieur des trous.

L'invention se rapporte aussi à une carte à microcircuits électroniques, du type incorporant une pastille qui présente sur une face une couche métallique(15) présentant les contacts (13) de la carte et qui comporte au moins un circuit intégré, caractérisée en ce que la pastille résulte du dispositif tel que décrit précédemment.

Les caractéristiques et avantages de l'invention ressortiront de la description qui suit, faite à titre d'exemple en référence aux dessins annexés.

Dans les dessins :

- la figure 1 est une vue en coupe, suivant la ligne I-I indiquée à la figure 2, d'un mode de réalisation d'une pastille conforme à l'invention, montée dans une carte portative illustrée partiellement ;
- la figure 2 est une vue de dessus de la pastille et de la partie de carte représentées sur la figure 1 ;
- les figures 3A et 3B sont des vues de détail agrandies au niveau d'un trou de connexion de la pastille représentée sur la figure 1, illustrant les deux étapes fondamentales du procédé de montage d'une puce sur un support conformément à l'invention ;
- la figure 4 est une vue en coupe partielle, similaire à celle de la figure 1, illustrant une variante de réalisation d'un dispositif de polarisation de la puce pour une pastille conforme à l'invention ;
- la figure 5 est une vue en coupe similaire à celle de la figure 1 d'une variante de réalisation d'une pastille conforme à l'invention ;
- la figure 6 est une vue en perspective d'une variante de réalisation d'un dispositif conforme à l'invention, à partir duquel il est suggéré les diverses étapes de fabrication et d'utilisation de ce dispositif ;
- la figure 7 est une vue en coupe, faite suivant la ligne VII-VIII indiquée à la figure 8 et similaire à celle de la figure 1, d'une variante de réalisation d'une pastille conforme à l'invention, montée dans une carte portative illustrée partiellement ; et
- la figure 8 est une vue de dessus, similaire à celle de la figure 2, de la pastille et de la partie de carte représentées sur la figure 7.

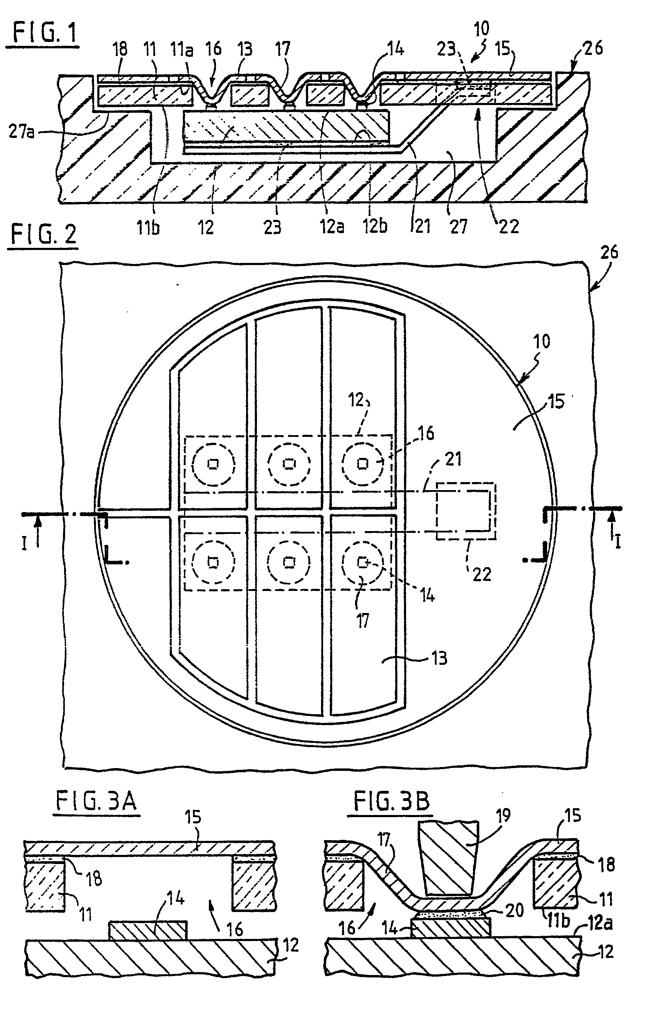

Les figures 1 et 2 illustrent le mode de réalisation préféré d'un dispositif porteur d'un circuit intégré. Ce dispositif se présente sous la forme d'une pastille (10) composée essentiellement d'un support (11), d'une puce (12) et de contacts (13).

La puce (12) porte sur sa face active (12a) des circuits intégrés connectés à des éléments de connexion (14) de la puce, constitués dans l'exemple illustré par six plots. Le support (11) est une mince feuille en matériau électriquement isolant, tel que celui connu sous la marque déposée "Kapton". La face (11a) du support (11) est en grande partie recouverte par une couche métallique (15) constituant notamment les contacts (13) de la pastille (10). La couche métallique (15) est généralement formée par une mince feuille de cuivre fixée contre la face (11a) du support (11) par une couche de colle (18), puis dûment gravée et dorée. La puce (12) est disposée de l'autre côté (11b) du support (11), de manière que ses six plots (14) soient en regard des six trous respectifs (16) ménagés dans le support sous six contacts correspondants (13) de la couche métallique (15), comme représenté sur la figure 3A. Dans la pratique, les six trous (16) sont percés dans le support avant la mise en place de la couche métallique (15).

Les éléments de connexion de la puce (12), constitués dans l'exemple illustré par les six plots (14), sont soudés aux contacts respectifs (13) en regard des trous (16). La figure 3A représente l'état initial de la pastille avant soudage. Cet état correspond aussi à l'état initial du procédé de soudage antérieur décrit dans le brevet précité n° 2 439 322.

Selon l'invention, le soudage est fait sur des bossages (17) obtenus par déformation de la couche métallique (15) vers l'intérieur de chaque trou (16).

La figure 3B illustre à titre d'exemple le procédé conforme à l'invention. Un outil (19), abaissé coaxialement au trou (16) illustré, déforme la couche métallique (15) au niveau d'un contact (13) pour former un bossage (17). De préférence, comme illustré, l'outil (19) sera aussi un outil de soudage pour fixer le bossage (17) dès qu'il vient en contact avec le plot (14). Il est clair cependant que les opérations de déformation et de soudage peuvent être espacées dans le temps et effectuées avec des outils spécifiques différents. De même, la déformation de la couche métallique (15) peut intervenir à tout moment, depuis son état initial à l'état de cuivre jusqu'à son état final, sous forme de contacts, qui a servi d'exemple.

Le mode de soudage des plots (14) aux bossages (17) qui est représenté sur la figure 3B consiste à former de manière classique un alliage or-étain (20) voisin de l'eutectique. Cependant, tout autre mode de soudage peut être utilisé, notamment la thermocompression qui est aussi couramment utilisée dans cette technique.

En pratique, le procédé conforme à l'invention s'applique à une puce (12) classique, dont les plots (14) ont une hauteur très faible par rapport à la face active (12a) de la puce, de l'ordre de quelques micromètres, 2 um par exemple. Compte tenu de l'épaisseur du support, de l'ordre de 100 um en pratique, le sommet de chaque bossage (17) doit affleurer approximativement la face (11b) du support (11) pour être soudé au plot (14) respectif d'une puce ayant

sa face (11a) pratiquement en contact avec la face (11b) du support. Pour la clarté des dessins, les figures ne respectent pas les proportions réelles des éléments représentés.

D'autre part, bien que les trous (16) puissent avoir des dimensions quelconques par rapport à l'épaisseur du support (11), le fait de leur donner un diamètre notablement supérieur à l'épaisseur du support a l'avantage de restreindre les contraintes à exercer sur la couche métallique (15) pour former les bossages (17) et de procurer à la pastille (10) une plus grande résistance à l'encontre des forces de flexion et de torsion que la pastille peut subir. Dans l'exemple précité où le support a environ 0,1 mm d'épaisseur, des trous de l'ordre du millimètre ont été utilisés avec profit.

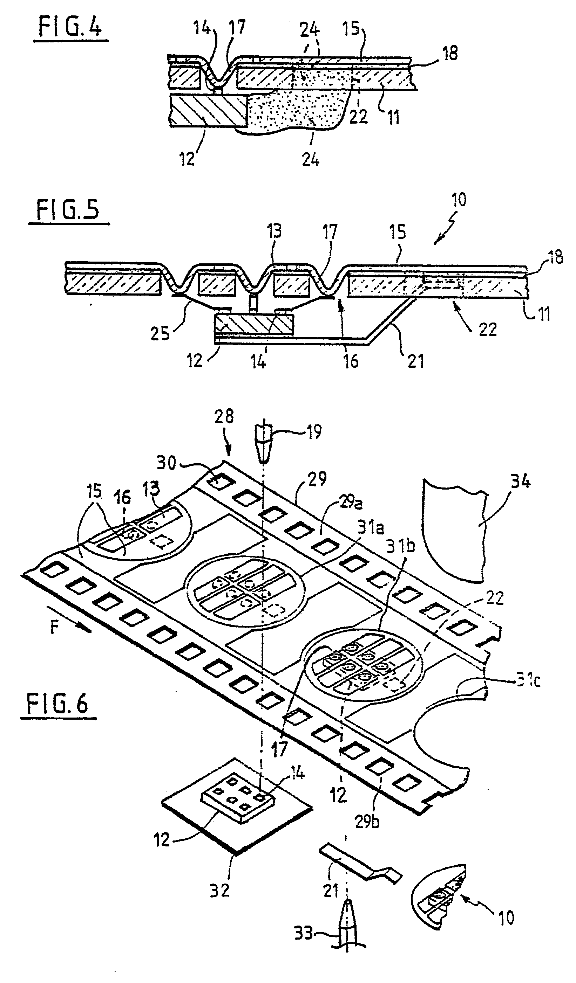

Il ressort des figures 1 et 2 que la pastille (10) pourrait normalement se limiter à l'emploi d'un support (11), d'une couche métallique (15) dûment déformée pour constituer les bossages (17) dans les trous (16), et d'une puce (12) dont les plots (14) sont soudés aux bossages (17). Cependant, dans le cas où les circuits intégrés de la puce (12) sont du type N-MOS, il est nécessaire de polariser la base (12b) de la puce. Les exemples illustrés tiennent compte de cette éventualité et proposent différents dispositifs de polarisation. Dans les figures 1 et 2, le dispositif de polarisation représenté est formé d'une lame métallique conductrice (21) reliant la base (12b) de la puce (12) à l'un des contacts (13) de la couche métallique (15) à travers un trou (22) du support (11). La liaison illustrée de la lame (21) à la puce (12) et au contact (13) est faite par des couches respectives (23) de colle conductrice, par exemple de l'époxy chargé en argent. Eventuellement, la lame (21) pourrait simplement servir de drain thermique. Une variante de réalisation telle qu'illustrée dans la figure 4 consiste à remplacer la lame (21) par une masse de colle conductrice (24) qui remplit le trou (22) et se prolonge jusqu'à une paroi de la puce (12).

A la figure 5, la pastille (10) conforme à l'invention est adaptée à une puce (12) de taille trop petite pour que ses plots (14) puissent être directement connectés aux bossages (17) des contacts (13). La puce (12) est donc pourvue de pattes (25) dont les extrémités sont soudées aux bossages (17).

Les figures 1 et 2 illustrent également l'application de la pastille (10) à la réalisation d'une carte portative (26). L'exemple de réalisation représenté correspond à celui décrit dans le brevet français n° 2 337 381 de la demanderesse. Selon ce brevet, la carte est une simple feuille faite en un matériau plastique et pourvue d'une cavité (27) conformée pour contenir et fixer la pastille (10) de façon que les contacts (13) soient sensiblement coplanaires avec la face correspondante de la carte (27). La fixation est généralement faite par collage (non représenté) de la périphérie du support (11) sur un épaulement correspondant (27a) de la cavité (27). Cependant, on comprend que l'invention ne se limite pas à ce mode de réalisation et que la pastille (10) peut par exemple être simplement noyée dans le matériau plastique de la carte.

La figure 6 illustre une variante de réalisation d'un dispositif porteur de circuits intégrés conforme à l'invention. Selon cette variante, le dispositif (28) a un support (29) se présentant sous la forme d'un film plastique de type cinématographique à double rangée de perforations (30) régulièrement espacée le long des bords du film. Le support (29) est partagé en une série de domaines adjacents (31a, 31b, 31c, ...) destinés à reproduire chacun la même structure que celle de la pastille (10) représentée sur les figures 1 et 2. La figure 5 attribue donc les mêmes chiffres de référence aux composants analogues à ceux de la pastille (10). Ainsi, le support (29) de chaque domaine (31) est percé de six trous (16) et d'un trou additionnel (22). Un ruban de cuivre (15) est ensuite collé sur une face du support (29), puis gravé et doré pour former les contacts (13) recouvrant les trous de chaque domaine (31) illustré.

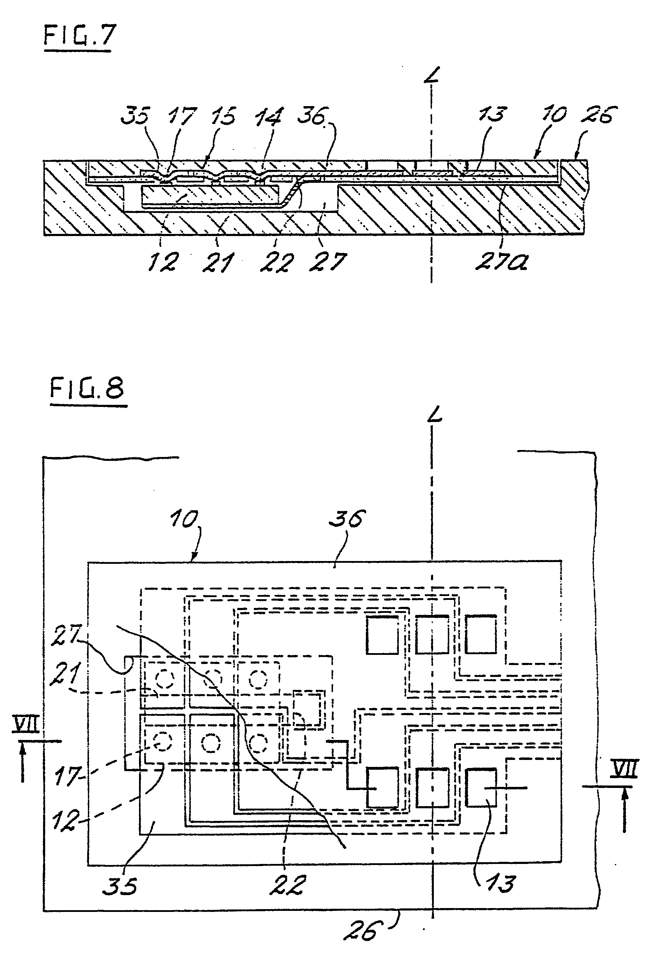

A partir de cet état initial des domaines (31) du film (29), la figure 6 illustre schématiquement les étapes du procédé conforme à l'invention pour l'élaboration de pastilles (10) telles que représentées sur les figures 1 et 2. Il est supposé qu'à chaque domaine successif est opérée une phase différente du procédé tel que décrit en référence aux figures 3A, 3B, lorsque le film se déroule dans le sens de la flèche (F). Le domaine (31a) vient se positionner par rapport à une puce (12) portée par une table (32). Au-dessus des contacts (13), l'outil (19) produit des bossages (17) et effectue le soudage de ces bossages aux plots (14) de la puce (12). Il en résulte la configuration représentée dans le domaine (31b) du dispositif (28). Au niveau de ce domaine, un dispositif d'application de colle (33), tel qu'une seringue ou un tampon, dépose des couches de colle (23) sous la puce (12) et dans le trou (22). La mise en place de la lame (21) aboutit, dans le domaine (31c), à la configuration de la pastille (10) représentée sur les figures 1 et 2 et illustrée de façon fragmentaire sur la figure 7 après l'action d'une matrice de découpage (34) pour prélever la pastille (10) du dispositif (28).

Les figures 7 et 8 sont des vues respectivement analogues à celles des figures 1 et 2 d'une variante de réalisation d'une pastille (10) conforme à l'invention. Les mêmes chiffres de référence désignent les mêmes éléments. Selon la variante des figures 7 et 8 les contacts (13) sont situés dans une zone située en dehors de la cavité (27) incorporant la puce (12). La pastille (10) corespondante est de ce fait appelée pastille à contacts décalés. Dans l'exemple de la figure 8, la pastille (10) est placée dans la carte de manière que les contacts (13) soient disposés au niveau de la ligne médiane (L) parallèle à la longueur de la carte et que la puce demeure logée dans un coin de la carte. Ainsi, les contraintes exercées sur la puce par la flexion et la torsion de la carte sont réduits par rapport à celles que subirait une puce placée au niveau des contacts (13) comme dans le cas des figures 1 et 2. Selon l'exemple des figures 7 et 8, la couche métallique (15) se compose de six bandes (35) présentant chacune à une extrémité un bossage (17) et, à l'autre extrémité, un contact correspondant (13). Les contacts (13) sont délimités par des trous respectif ménagés dans un film de matière plastique isolante (36) recouvrant toute la pastille (10). Éventuellement, les trous peuvent être remplis de matière conductrice. Dans l'exemple illustré, la bande centrale (35) est en outre reliée à la lame (21) par l'intermédiaire du trou (22). Autrement, une bande (35) supplémentaire pourrait évidemment être attribuée à la liaison de la lame (21) à un contact respectif (13). Il est ainsi évident que tous les modes de réalisation illustrés dans les figures 1 à 8 peuvent s'adapter les uns aux autres.

## Revendications

1. Procédé de montage d'un circuit intégré (12) sur un support (11), consistant à percer des trous (16) dans le support, à fermer les trous par une couche métallique (15) appliquée sur une face (11a) du support et à souder en regard des trous les éléments de connexion (14,25) du circuit intégré (12) à la couche métallique (15), caractérisé en ce que, avant le soudage, il consiste à déformer la couche métallique vers l'intérieur de chacun des trous pour y constituer des bossages (17).

2. Procédé selon la revendication 1, caractérisé en ce qu'il consiste à faire affleurer sensiblement les sommets des bossages (17) avec l'autre face (11b) du support (11).

3. Procédé selon la revendication 1 ou 2, caractérisé en ce qu'il consiste à relier électriquement une paroi du circuit intégré (12) à la couche métallique (15) à travers un trou (22) traversant le support (11) sous la couche (15).

4. Dispositif (10, 28) porteur de circuits intégrés (12), comprenant un support (11, 29) percé de trous (16) et ayant une face (11a, 29a) pourvue d'une couche métallique (15) fermant les trous (16), caractérisé en ce que la couche métallique présente des bossages (17) vers l'intérieur des trous.

5. Dispositif selon la revendication 4, caractérisé en ce que le support (29) est un film du type cinématographique présentant des domaines adjacents (31a, 31b, ...) identiques, pourvus d'une couche métallique (15) présentant des bossages (17) formés dans des trous respectifs (16) du support (29).

6. Dispositif selon la revendication 4 ou 5, caractérisé en ce que les sommets des bossages (17) affleurent approximativement l'autre face (11b, 29b) du support.

7. Dispositif selon l'une des revendication 4 à 6, caractérisé en ce que les trous (16) ont un diamètre notablement supérieur à l'épaisseur du support.

8. Dispositif selon l'une des revendications 4 à 7, caractérisé en ce que les éléments de connexion (14, 25) d'au moins un circuit intégré (12) sont respectivement soudés sur les sommets des bossages (17).

9. Dispositif selon la revendication 8, caractérisé en ce que les éléments de connexion sont les plots (14) du circuit intégré.

10. Dispositif selon la revendication 8, caractérisé en ce que les éléments de connexion sont les pattes (25) du circuit intégré.

11. Dispositif selon la revendication 8, caractérisé en ce qu'il comporte un dispositif de polarisation (21, 24) entre une paroi du circuit intégré et la couche métallique à travers un trou (22) traversant le support sous la couche métallique.

12. Dispositif selon la revendication 11, caractérisé en ce que le dispositif de polarisation est une lame métallique conductrice (21) fixée au dos (12b) du circuit intégré (12).

13. Dispositif selon la revendication 11, caractérisé en ce que le dispositif de polarisation est formé par de la colle conductrice (24).

14. Dispositif selon l'une des revendications 4 à 13, caractérisé en ce que la couche métallique (15) qui ferme les trous (16) constitue des contacts respectifs (13) du dispositif.

15. Dispositif selon l'une des revendications 4 à 13, caractérisé en ce que la couche métallique (15) se compose de bandes (35) présentant chacune à une extrémité un bossage (17) et à une autre extrémité un contact (13).

16. Dispositif selon la revendication 14 ou 15 caractérisé en ce qu'il est recouvert d'un film isolant (36) pourvu de trous délimitant les contacts (13).

17. Carte (26) à microcircuits électroniques, du type incorporant une pastille (10) qui présente sur une face une couche métallique (15) présentant les contacts (13) de la carte et qui comporte au moins un circuit intégré (12), caractérisée en ce que la pastille (10) résulte du dispositif tel que décrit dans l'une des revendications 4 à 16.

18. Carte selon la revendication 17, caractérisée en ce que le circuit intégré (12) est placé dans un coin de la carte tandis que les contacts (13) sont situés dans une zone médiane de la carte.

## Claims

1. A method of mounting an integrated circuit (12) on a support (11), consisting in piercing holes (16) into the support; in closing the holes by a metallic layer (15) applied on one face (11a) of the support and; in welding the connecting elements (14, 25) of the integrated circuit (12) opposite the holes to metallic layer (15), characterised in that, prior to the welding operation, it consists in deforming the metallic layer towards the interior of each of the holes to form projections (17) therein.

2. A process according to claim 1, characterised in that it consists in making the peaks of the projections (17) lie substantially flush with the other face (11b) of the support (11).

3. A process according to claim 1 or 2, characterised in that it consists in electrically connecting one side of the integrated circuit (12) with the metallic layer (15) through a hole (22) passing through the support (11) beneath the layer (15).

4. A device (10, 28) carrying integrated circuits (12), comprising a support (11, 29) pierced with holes (16) and having one face (11a, 29a) provided with a metallic layer (15) closing the holes (16), characterised in that the metallic layer has projections (17) towards the interior of the holes.

5. A device according to claim 4, characterised in that the support (29) is a film of the cinematographic type presenting identical adjacent areas (31a, 31b, ...) provided with a metallic layer (15) having projections (17) formed in respective holes (16) of the support (29).

6. A device according to claim 4 or 5, characterised in that the peaks of the projections (17) lie approximately flush with the other surface (11b, 29b) of the support.

7. A device according to one of the claims 4 to 6, characterised in that the holes (16) have a diameter notably greater than the thickness of the support.

8. A device according to one of the claims 4 to 7, characterised in that the connecting elements (14, 25) of at least one integrated circuit (12) are welded respectively to the peaks of the projections (17).

9. A device according to claim 8, characterised in that the connecting elements are the contact studs (14) of the integrated circuit.

10. A device according to claim 8, characterised in that the connecting elements are the lugs (25) of the integrated circuit.

11. A device according to claim 8, characterised in that it comprises a polarisation device (21, 24) between one side of the integrated circuit and the metallic layer passing through a hole (22) traversing the support beneath the metallic layer.

12. A device according to claim 11, characterised in that the polarisation device is a conductive metallic blade (21) fixed to the back (12b) of the integrated circuit (12).

13. A device according to claim 11, characterised in that the polarisation device is formed by conductive adhesive (24).

14. A device according to one of the claims 4 to 13, characterised in that the metallic layer (15) which closes the holes (16) forms respective contacts (13) of the device.

15. A device according to one of the claims 4 to 13, characterised in that the metallic layer (15) comprises strips (35) each having a projection (17) at one end and a contact (13) at the other end.

16. A device according to claim 14 or 15, characterised in that it is covered by an insulating film (36) provided with holes delimiting the contacts (13).

17. An electronic microcircuit card (26) of the type incorporating a microchip (10) which has on one face a metallic layer (15) providing the contacts (13) of the card and which comprises at least one integrated circuit (12), characterised in that the microchip (10) results from a device like that described in one of the claims 4 to 16.

18. A card according to claim 17, characterised in that the integrated circuit (12) is placed in a corner of the card, whereas the contacts (13) are situated in a central area of the card.

## Patentansprüche

1. Verfahren für das Montieren einer integrierten Schaltung (12) auf einen Träger (11), darin bestehend, Löcher (16) in den Träger zu bohren, die Bohrungen mit einer auf eine Fläche (11a) des Trägers aufgebrachten Metallschicht (15) zu verschließen und den Bohrungen gegenüberliegend Elemente zur Verbindung (14, 25) der integrierten Schaltung (12) mit der Metallschicht (15) aufzulöten, dadurch gekennzeichnet, daß das Verfahren darin besteht, vor dem Löten die Metallschicht nach dem Inneren jeder der Bohrungen zu verformen, um dort Ausbuchtungen (17) zu bilden.

2. Verfahren nach Anspruch 1, dadurch gekennzeichnet, daß es darin besteht, die Spitzen der Ausbuchtungen (17) etwa an die andere Fläche (11b) des Trägers (11) herantreten zu lassen.

3. Verfahren nach Anspruch 1 oder 2, dadurch gekennzeichnet, daß es darin besteht, durch eine den Träger (11) unter der Schicht (15) durchquerende Bohrung (22) eine Wand der integrierten Schaltung (12) mit der Metallschicht (15) elektrisch zu verbinden.

4. Trägerelement (10, 28) zur Aufnahme von integrierten Schaltungen (12), umfassend einen Träger (11, 29), der von Löchern (16) durchbohrt ist und eine Fläche (11a, 29a) hat, die mit einer die Bohrungen (16) verschließenden Metallschicht (15) versehen ist, dadurch gekennzeichnet, daß die Metallschicht Ausbuchtungen (17) nach dem Inneren der Bohrungen hin aufweist.

5. Element nach Anspruch 4, dadurch gekennzeichnet, daß der Träger (29) ein Film der in der Filmkunst üblichen Art ist, der identische angrenzende Bereiche (31a, 31b, ...) aufweist, die mit einer Metallschicht (15) versehen sind, die in jeweiligen Bohrungen (16) des Trägers (29) gebildete Ausbuchtungen (17) aufweist.

6. Element nach Anspruch 4 oder 5, dadurch gekennzeichnet, daß die Spitzen der Ausbuchtungen (17) ungefähr an die andere Fläche (11b, 29b) des Trägers herantreten.

7. Element nach einem der Ansprüche 4 bis 6, dadurch gekennzeichnet, daß die Bohrungen (16) einen beträchtlich größeren Durchmesser als die Trägerdicke haben.

8. Element nach einem der Ansprüche 4 bis 7, dadurch gekennzeichnet, daß die Verbindungselemente (14, 25) mindestens einer integrierten Schaltung (12) jeweils auf die Spitzen der Ausbuchtungen (17) gelötet sind.

9. Element nach Anspruch 8, dadurch gekennzeichnet, daß die Verbindungselemente die Lötstifte (14) der integrierten Schaltung sind.

10. Element nach Anspruch 8, dadurch gekennzeichnet, daß die Verbindungselemente die Lötfahnen (25) der integrierten Schaltung sind.

11. Element nach Anspruch 8, dadurch gekennzeichnet, daß es ein Polarisationselement (21, 24) zwischen einer Wand der integrierten Schaltung und der Metallschicht durch eine den Träger unter der Metallschicht durchquerende Bohrung (22) hindurch umfaßt.

12. Element nach Anspruch 11, dadurch gekennzeichnet, daß das Polarisationselement ein auf der Rückseite (12b) der integrierten Sohaltung (12) befestigter leitfähiger Metallstreifen (21) ist.

13. Element nach Anspruch 11, dadurch gekennzeichnet, daß das Polarisationselement durch einen leitfähigen Kleber (24) gebildet wird.

14. Element nach einem der Ansprüche 4 bis 13, dadurch gekennzeichnet, daß die die Bohrungen (16) verschließende Metallschicht (15) jeweilige Kontakte (13) des Elements bildet.

15. Element nach einem der Ansprüche 4 bis 13, dadurch gekennzeichnet, daß sich die Metallschicht (15) aus Streifen (35) zusammensetzt, von denen jeder an dem einen Ende eine Ausbuchtung (17) und an dem anderen Ende einen Kontakt (13) aufweist.

16. Element nach Anspruch 14 oder 15, dadurch gekennzeichnet, daß es mit einem Isolierfilm (36) bedeckt ist, der mit die Kontakte (13) begrenzenden Bohrungen versehen ist.

17. Karte (26) mit elektronischen Mikroschaltungen von der Art, die eine Pastille (10) umfaßt, die auf einer Fläche eine Metallschicht (15) mit den Kartenkontakten (13) aufweist und die mindestens eine integrierte Schaltung (12) umfaßt, dadurch gekennzeichnet, daß die Pastille (10) von einem wie in einem der Ansprüche 4 bis 16 beschriebenen Element stammt.

18. Karte nach Anspruch 17, dadurch gekennzeichnet, daß die integrierte Schaltung (12) in einer Ecke der Karte untergebracht ist, wohingegen die Kontakte (13) in einer Mittelzone der Karte gelegen sind.

FIG. 1

FIG. 2

FIG. 3A

FIG. 3B

FIG.4

FIG.5

FIG.6

FIG.7

FIG.8